# EUROPEAN PATENT SPECIFICATION

(11) **EP 4 640 024 B1**
(45) Date of publication and mention of the grant of the patent: **02.12.2026**
(21) Application number: 23833604.4
(22) Date of filing: 19.12.2023
(51) Int. Cl.: H10N 30/06, H10N 30/078, H10N 30/853, H10N 30/87, G02F 1/03, H03H 3/08, H03H 9/02, H03H 9/12

(54) **TRANSPARENT FERROELECTRIC DEVICE AND METHOD FOR MANUFACTURING THE SAME**
TRANSPARENTE FERROELEKTRISCHE VORRICHTUNG UND VERFAHREN ZU IHRER HERSTELLUNG
DISPOSITIF FERROÉLECTRIQUE TRANSPARENT ET SON PROCÉDÉ DE FABRICATION

(30) Priority: 19.12.2022 LU 503207
(43) Date of publication of application: 29.10.2025
(73) Proprietor: Luxembourg Institute of Science and Technology (LIST), 4362 Esch-sur-Alzette (LU)
(72) Inventor: GRANZOW, Torsten, 4362 Esch-Sur-Alzette (LU); BLAZQUEZ MARTINEZ, Alfredo, 4362 Esch-Sur-Alzette (LU)
(74) Representative: Ipsilon Luxembourg
(86) International application number: PCT/EP2023/025542
(87) International publication number: WO 2024/132208

(56) References cited:
- EP-A1- 3 157 061
- WO-A1-2021/148630
- CN-A- 105 185 898
- CHEN-FU LIN ET AL: "Back-contact perovskite solar cells", SEMICONDUCTOR SCIENCE TECHNOLOGY, IOP PUBLISHING LTD, GB, vol. 36, no. 8, 9 July 2021 (2021-07-09), pages 83001, XP020368103, ISSN: 0268-1242, [retrieved on 20210709], DOI: 10.1088/1361-6641/AC0577

## Description

### Technical field

The invention relates to the field of microsystem manufacturing and especially the manufacturing of electrooptic or piezoelectric devices obtained by deposition of components on a substrate, with in-plane electric field.

### Background art

Some electronic devices may benefit from being transparent: electrooptic applications modifying the refractive index of a system; touchscreens; electrooptic wavelength division multiplexer; Pockels cells; transmission filters; tunable waveguides; tunable retardation systems; transparent acoustic wave filters or resonators (SAW/BAW); SAW haptic feedback devices; etc.

A known design is presented in document WO 2021/148630 A1. Electrodes made of indium-tin oxide (ITO) are deposited on a piezoelectric layer. This design is complex to manufacture. Also, this device shows that the low dielectric rigidity can be improved by adding a further insulating layer of SU8, thereby complexifying even further the manufacturing process. In addition, this known device cannot be used above 200°C (SU8 will turn black beyond that temperature). Thus, the possible applications for this device are limited. Finally, because of the number of elements stacked onto each other in this device, the degree of transparency can be found insufficient for some applications.

The document CN105185898A relates to a flexible and transparent micro-functional device and preparation thereof. The device achieves a high flexibility by thinning the mica substrate and exhibits a high transparency for application in pressure sensors, flexible displays or wearable devices.

### Summary of invention

### Technical problem

The present invention addresses the above-mentioned deficiencies and aims at providing a transparent device and manufacturing method thereof, the device having a higher degree of transparency, while being easier to manufacture and enabling a wider range of applications.

### Solution

The above-stated problem is solved by a method for manufacturing a transparent electrooptic or piezoelectric microsystem, the method comprising the steps of: providing a transparent substrate; forming electrodes directly on the transparent substrate, the electrodes being transparent interdigitated electrodes made of fluorine-doped tin oxide, FTO; and embedding the electrodes in a ferroelectric film.

The combination of these only two elements (FTO embedded in a ferroelectric film) enables the device to be functional under more than 200 kV/mm and at a temperature up to 600°C, thereby broadening the range of possible applications for the device, while ensuring a simple manufacturing process. In comparison with known methods, an insulating layer is here not necessary, which means that the manufacturing process is simplified, the transparency is improved and the physical constraints inherent to the insulating layer and limiting the range of application are waived.

Embedding a transparent non-metallic interdigitated electrodes with a ferroelectric film is particularly innovative.

Incidentally, the electric field is more homogenous and the surface roughness is smoother than in a device where the electrodes are not embedded in a layer. Hence, the overall haptic quality of the device is improved in comparison with known devices.

According to an advantageous embodiment, the step of forming electrodes comprises: forming a negative interdigitated pattern in a sacrificial layer; sputter-deposing FTO; and washing out of the sacrificial layer.

According to an advantageous embodiment, the method comprises a step of annealing the substrate and the electrodes at a temperature of at least 500°C before embedding the electrodes in a ferroelectric film. This first annealing step (of the FTO before film deposition) enables to ensure good electrical properties for the electrodes. Without annealing, the FTO electrodes will have a lower conductivity and a lower transparency.

According to an advantageous embodiment, the method comprises a step of annealing the substrate, the electrodes and the ferroelectric film after the step embedding. This second annealing step (after the film has been deposited) enables to crystallize the film. Without this step, the oxide film will be non-ferroelectric and amorphous.

According to an advantageous embodiment, the substrate is made of fused silica, sapphire or MgO.

According to an advantageous embodiment, the step of embedding the electrodes comprises spin coating a solution of Pb(ZrₓTi₁₋ₓ)O₃ (PZT), BiFeO₃ (BFO), KₓNa₁₋ₓNbO₃ (KNN) and/or PbZrO₃ (PZO) on the substrate and on the electrodes.

The inventors have demonstrated that, although it was unexpected, the ferroelectric layer and in particular BFO can be grown and have a proper grain structure on FTO. As there is no literature regarding a film of BFO embedding interdigitated electrodes of FTO, one could not have guessed that both elements, when directly in contact, would still allow good electrical properties (conductivity/hysteresis) for the electrodes, and a good transparency. For example, one would expect the electrical properties of the electrode to be affected by the diffusion of elements or by the high temperatures of the annealing (e.g. 600 °C) but the inventors have demonstrated that it wasn't the case. In addition, there was no expectation to obtain a good grain structure. The inventors have nevertheless found that particular parameters enable this additional benefit: by annealing the FTO in two steps (to maximize conductivity and transparency), depositing FTO on the developed photolithography resin, ultra-sonification for 10 minutes to perform the lift-off, and deposition of BFO at 600°C (+/-5%) under 2.026 bar (= 2 atmospheres) (+/-5%).

The invention also relates to a transparent electrooptic or piezoelectric microsystem comprising a transparent substrate; transparent interdigitated electrodes made of fluorine-doped tin oxide directly on the transparent substrate; and a ferroelectric film embedding the electrodes.

The microsystem is preferably made with the method steps mentioned above.

As exemplified below, analyses have shown that the microsystem is physically distinct from a microsystem obtained with other materials or other manufacturing methods.

### Brief description of the drawings

Figure 1 is a sketch of a microsystem device;
Figure 2 shows the transparency of the FTO under different annealing conditions;
Figures 3 and 4 show the electric performance of the FTO electrodes.

### Detailed description of the drawings

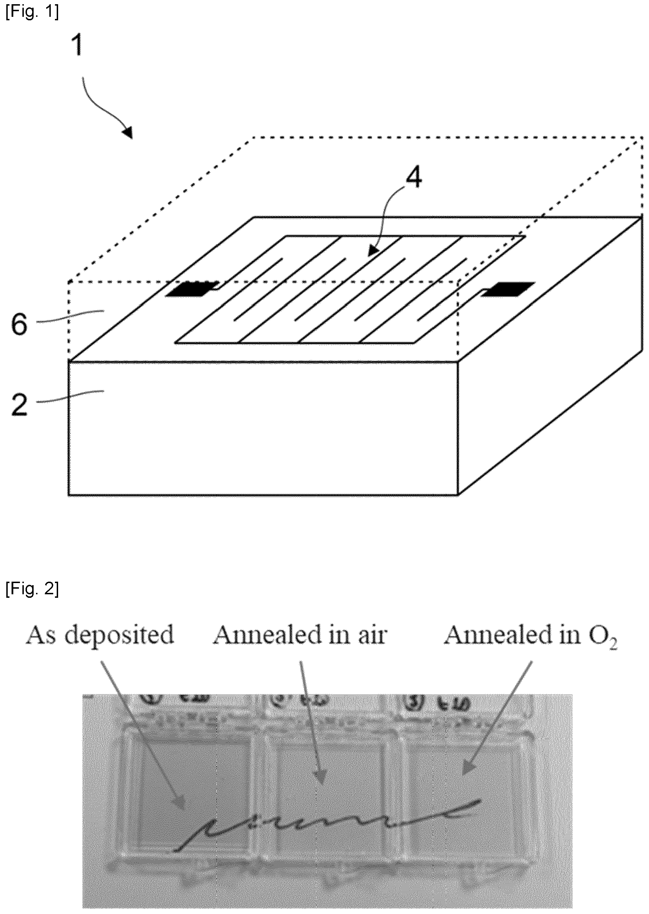

Figure 1 shows an illustration (not to scale) of a microsystem 1. The microsystem 1 comprises a substrate 2.

The substrate 2 may be made of fused silica glass or sapphire or magnesium oxide single crystals. Alternatively, it can be made of any inert transparent material which can remain transparent beyond 600°C.

In the present application, the term "transparent" is used to qualify a property of the various materials in their solid state, to transmit a substantial amount (at least 70%, preferably at least 80%) of incident light of the visible spectrum.

The microsystem 1 comprises interdigitated electrodes 4 (IDE), which are formed directly on the substrate 2.

The electrodes 4 may be formed by lift-off photolithography using direct laser writing or mask patterning. A sacrificial layer of resin can be deposited on the substrate. A negative pattern of recesses can be formed through the sacrificial layer. The electrode material can then be DC-sputtered in the negative pattern at room temperature. The sacrificial layer (and the FTO material sputtered on the resin) is finally washed out, for instance by ultra-sonification for 10 minutes. The electrodes can then be annealed at or above 500°C, for example for a duration of 5 minutes.

The electrodes 4 may comprise at least two interdigitated electrodes, IDE, each having a plurality of fingers and at least one terminal (contact pad) for their electrical connection to a circuit. The fingers can for example be spaced apart by 5 micrometers. The thickness of the electrodes may be of any appropriate dimension, for example around 100 nm.

The IDE geometry is only schematically illustrated in Fig. 1. The exact pattern (width of individual fingers, width of gap between fingers, number of fingers, size of contact pads at each end) will be chosen according to the intended application of the microsystem (in particular depending on the required cycling speed).

The material used to form the electrodes is fluorine-doped tin oxide.

The electrodes 4 are embedded in a transparent layer of ferroelectric thin film 6. This film 6 can be constituted of at least one of: Pb(ZrₓTi₁₋ₓ)O₃, BiFeO₃, KₓNa₁₋ₓNbO₃ and/or PbZrO₃. These materials are electrooptic and piezoelectric. The transparency of the device is mainly limited by the transparency of the ferroelectric layer, which can be lead-containing or lead-free.

The film can be spin coated to totally cover the electrodes and to cover at least the portion of the substrate in the area where the electrodes are located (the substrate may be substantially bigger than the electrodes). The solution of ferroelectric material can be spin coated at 3000 rpm for 30 seconds. The layer is then incrementally dried at 90°C and at 270°C. The operation can be repeated as needed until the ferroelectric film entirely covers the electrodes (for instance around 100 nm thick in total). Then, a pyrolysis at 450°C under oxygen atmosphere is carried out. Finally, the film may be annealed in a rapid thermal annealing furnace at 600°C for 90 seconds. Alternatively, the deposition can be made by inkjet printing, sputtering, Pulsed Laser Deposition, MOCVD, atomic layer deposition, etc.

Before using the device, the ferroelectric film may be poled by applying a high voltage to the IDE structure, which in turn creates an in-plane electric field in the film. Once the film is poled, any further application of an external field will change the refractive index of the film via the linear electrooptic (Pockels) effect, and will change the dimension of the film (the piezoelectric effect).

Antiferroelectric films can alternatively be used. These do not require an initial poling step, but require high voltages for enabling a discontinuous change of refractive indices and strain when the field exceeds the threshold field for and antiferroelectric-ferroelectric phase transition.

In comparison, the films used in prior art cannot be submitted to a voltage sufficient for them to pole unless coated with an additional insulating layer.

The microsystem of the invention constitutes a substantial improvement over the known systems. Figures 2 to 4 highlight this improvement.

Figure 2 shows a comparison of the transparency of a layer of FTO, as deposited (before annealing on the left-hand side), a layer of FTO annealed in air (middle section) and a layer of FTO annealed under oxygen (righthand side). The samples are here positioned over a white paper with a line made with a black pen. One can clearly see the improvement in terms of transparency. The figure 2 also shows that irrespective of the atmosphere (air or O₂) for the annealing, the layer of FTO maintains a good transparency. This means that the materials used in the invention render the manufacturing process of the invention also simpler as the annealing step does not need to be carried out under controlled atmosphere.

The tests show that the transparency is improved by about 50%.

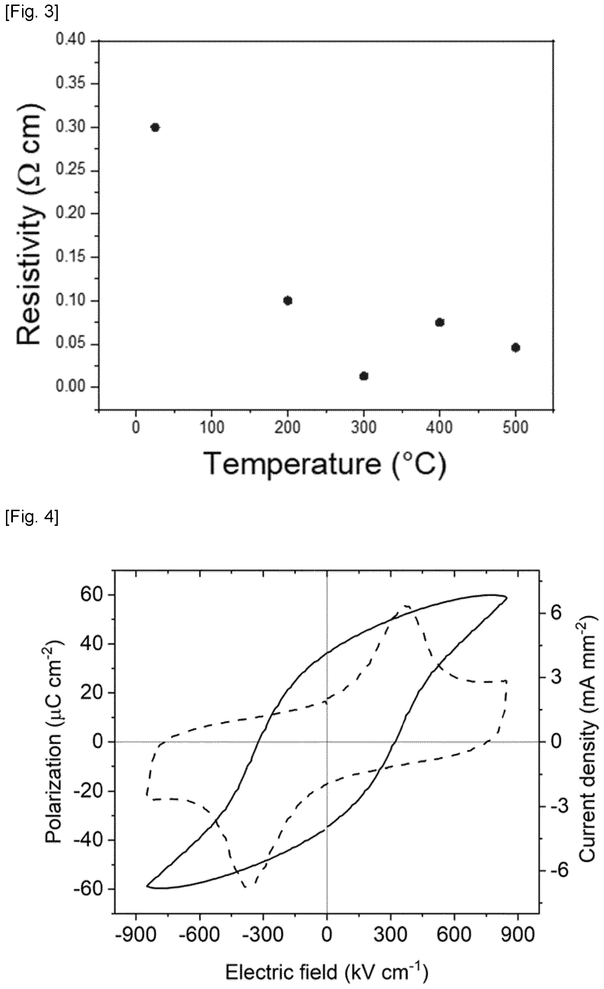

Figure 3 shows a comparison of the resistivity of the FTO electrodes of the device of the invention when annealed at different temperatures. FTO can be annealed at high temperatures up to 500°C without losing the conductivity properties, which is beneficial for broadening the possible applications of the device of the invention.

Figure 4 shows the polarization - electric field and current density - electric field hysteresis loops of the device, when the ferroelectric film is BiFeO₃, measured at 1 kHz. The ferroelectric performance and electrical breakdown strength are comparable to those of systems with electrodes embedded in SU8.

The device remains usable from 200-600°C and the absence of various elements makes the manufacturing process simpler while improving the usability and quality of the device.

It is therefore concluded that the embedment of IDEs made of FTO into a ferroelectric film is responsible for the improvement of the IDE-made microsystem in terms of transparency, manufacturing process, and potential range of applications.

The exemplary embodiments presented above and the various quantities and numbers are given to illustrate the invention. The person skilled in the art would understand that the scope of the invention is only limited by the appended claims and that variations in the temperatures, the spinning speed or the time duration for the various steps of the method do not depart from the scope of the present invention. For example, variations of about 10% to 20% in the duration of the steps, the temperatures or the speed of the spinner can be used.

## Claims

1. Method for manufacturing a transparent electrooptic or piezoelectric microsystem (1), the method comprising the steps of:
providing a transparent substrate (2);
forming electrodes (4) directly on the transparent substrate (2), the electrodes (4) being transparent interdigitated electrodes (4) made of fluorine-doped tin oxide, FTO; and
embedding the electrodes (4) in a ferroelectric film (6).

2. Method according to claim 1, **characterized in that** the step of forming electrodes (4) comprises: forming a negative interdigitated pattern in a sacrificial layer; sputter-deposing FTO; and washing out of the sacrificial layer.

3. Method according to claim 1 or 2, **characterized by** comprising a step of annealing the substrate (2) and the electrodes (4) at a temperature of at least 500°C before embedding the electrodes in a ferroelectric film (6).

4. Method according to any of claims 1 to 3, **characterized by** a step of annealing the substrate (2), the electrodes (4) and the ferroelectric film (6) after the step of embedding the electrodes.

5. Method according to any of claims 1 to 4, **characterized in that** the substrate (2) is made of fused silica, sapphire or MgO.

6. Method according to any of claims 1 to 5, **characterized in that** the step of embedding the electrodes (4) comprises spin coating a solution of Pb(ZrₓTi₁₋ₓ)O₃, BiFeO₃, KₓNa₁₋ₓNbO₃ and/or PbZrO₃ on the substrate (2) and on the electrodes (4).

7. Transparent electrooptic or piezoelectric microsystem (1) comprising a transparent substrate (2); transparent interdigitated electrodes (4) made of fluorine-doped tin oxide directly on the transparent substrate; and a ferroelectric film (6) embedding the electrodes (4).

8. Microsystem according to claim 7 and manufactured at least partly with the method according to any of the claims 1 to 6.

## Patentansprüche

1. Verfahren zur Herstellung eines transparenten elektrooptischen oder piezoelektrischen Mikrosystems (1), wobei das Verfahren folgende Schritte umfasst:
Bereitstellen eines transparenten Substrats (2);
direktes Ausbilden von Elektroden (4) auf dem transparenten Substrat (2), wobei die Elektroden (4) transparente, interdigitierte Elektroden (4) aus Fluor-dotiertem Zinnoxid (FTO) sind; und
Einbetten der Elektroden (4) in eine ferroelektrische Schicht (6).

2. Verfahren nach Anspruch 1, **dadurch gekennzeichnet, dass** der Schritt des Ausbildens der Elektroden (4) Folgendes umfasst: Ausbilden eines negativen interdigitalen Musters in einer Opferschicht; Aufbringen von FTO mittels Sputtern; und Auswaschen der Opferschicht.

3. Verfahren nach Anspruch 1 oder 2, **dadurch gekennzeichnet, dass** es einen Schritt des Anlassens des Substrats (2) und der Elektroden (4) bei einer Temperatur von mindestens 500 °C vor dem Einbetten der Elektroden in eine ferroelektrische Schicht (6) umfasst.

4. Verfahren nach einem der Ansprüche 1 bis 3, **dadurch gekennzeichnet** durch einen Schritt des Anlassens des Substrats (2), der Elektroden (4) und der ferroelektrischen Schicht (6) nach dem Schritt des Einbettens der Elektroden.

5. Verfahren nach einem der Ansprüche 1 bis 4, **dadurch gekennzeichnet, dass** das Substrat (2) aus Quarzglas, Saphir oder MgO besteht.

6. Verfahren nach einem der Ansprüche 1 bis 5, **dadurch gekennzeichnet, dass** der Schritt des Einbettens der Elektroden (4) das Spin-Coating einer Lösung von Pb(ZrₓTi₁₋ₓ)O₃, BiFeO₃, KₓNa₁₋ₓNbO₃ und/oder PbZrO₃ auf das Substrat (2) und auf die Elektroden (4) umfasst.

7. Transparentes elektrooptisches oder piezoelektrisches Mikrosystem (1), umfassend ein transparentes Substrat (2); transparente, interdigitierte Elektroden (4) aus Fluor-dotiertem Zinnoxid direkt auf dem transparenten Substrat; und eine ferroelektrische Schicht (6), die die Elektroden (4) einbettet.

8. Mikrosystem nach Anspruch 7, das zumindest teilweise mit dem Verfahren nach einem der Ansprüche 1 bis 6 hergestellt ist.

## Revendications

1. Procédé de fabrication d'un microsystème (1) transparent électro-optique ou piézoélectrique, le procédé comprenant les étapes consistant à :
fournir un substrat transparent (2) ;
former des électrodes (4) directement sur le substrat transparent (2), les électrodes (4) étant des électrodes transparentes interdigitées (4) en oxyde d'étain dopé au fluor, FTO ; et
enrober les électrodes (4) dans une couche ferroélectrique (6).

2. Procédé selon la revendication 1, **caractérisé en ce que** l'étape de formation des électrodes (4) comprend : la formation d'un motif interdigité négatif dans une couche sacrificielle ; le dépôt par pulvérisation cathodique de FTO ; et le lavage de la couche sacrificielle.

3. Procédé selon la revendication 1 ou 2, **caractérisé en ce qu'**il comprend une étape de recuit du substrat (2) et des électrodes (4) à une température d'au moins 500°C avant l'enrobage des électrodes dans une couche ferroélectrique (6).

4. Procédé selon l'une quelconque des revendications 1 à 3, **caractérisé par** une étape de recuit du substrat (2), des électrodes (4) et de la couche ferroélectrique (6) après l'étape d'enrobage des électrodes.

5. Procédé selon l'une quelconque des revendications 1 à 4, **caractérisé en ce que** le substrat (2) est en silice fondue, en saphir ou en MgO.

6. Procédé selon l'une quelconque des revendications 1 à 5, **caractérisé en ce que** l'étape d'enrobage des électrodes (4) comprend un dépôt par centrifugation d'une solution de Pb(ZrₓTi₁₋ₓ)O₃, BiFeO₃, KₓNa₁₋ₓNbO₃ et/ou PbZrO₃ sur le substrat (2) et sur les électrodes (4).

7. Microsystème (1) transparent électro-optique ou piézoélectrique comprenant un substrat transparent (2) ; des électrodes (4) transparentes interdigitées en oxyde d'étain dopé au fluor directement sur le substrat transparent ; et une couche ferroélectrique (6) enrobant les électrodes (4).

8. Microsystème selon la revendication 7 et fabriqué au moins en partie selon le procédé conformément à l'une quelconque des revendications 1 à 6.
